# EUROPEAN PATENT SPECIFICATION

(11) **EP 0 692 141 B1**
(45) Date of publication and mention of the grant of the patent: **04.12.2002**
(21) Application number: 95908705.7
(22) Date of filing: 27.01.1995
(51) Int. Cl.: H01L 21/321, H01L 21/311

(54) **STRIPPING, PASSIVATION AND CORROSION INHIBITION OF SEMICONDUCTOR SUBSTRATES**
VERFAHREN ZUR PHOTOLACK-ENTFERNUNG, PASSIVIERUNG UND KORROSIONSINHIBIERUNG VON HALBLEITENDEN SCHEIBEN
DECAPAGE DE PHOTORESIST, PASSIVATION ET INHIBITION DE LA CORROSION DE SUBSTRATS A SEMI-CONDUCTEURS

(30) Priority: 03.02.1994 US 191828; 29.06.1994 US 268377; 09.01.1995 US 369953
(43) Date of publication of application: 17.01.1996
(73) Proprietor: Applied Materials, Inc., Santa Clara, CA 95054 (US)
(72) Inventor: CHEN, Jian, Santa Clara, CA 95051-2689 (US); HSIEH, Peter, Sunnyvale, CA 94087 (US); ISH-SHALOM, Carmel, 26418 Koriat Motzkin (IL); LAU, Wesley, San Jose, CA 95129 (US); PAPANU, James, S., San Rafael, CA 94903 (US); MAK, Steve, S., Y., Pleasanton, CA 94566 (US); RHOADES, Charles, Steven, Simi Valley, CA 93065 (US); SHIEH, Brian, Hualien (TW); LATCHFORD, Scott, Ian, Sunnyvale, CA 94087 (US); WILLIAMS, Karen, A., San Jose, CA 95128 (US); YU-WANG, Victoria, Los Altos, CA 94024 (US)
(74) Representative: Käck, Jürgen
(86) International application number: US9501100
(87) International publication number: WO95021458

(56) References cited:
- EP-A- 0 416 774
- EP-A- 0 489 179
- US-A- 5 174 856
- US-A- 5 200 031
- US-A- 5 221 424
- PATENT ABSTRACTS OF JAPAN vol. 12 no. 293 (E-645) ,10 August 1988 & JP,A,63 070428 (TSUKADA) 30 March 1988,
- JOURNAL OF THE ELECTROCHEMICAL SOCIETY, vol. 137,no. 8, August 1990 MANCHESTER, NEW HAMPSHIRE US, pages 2534-2538, XP 000151176 SHUICH ET AL 'Post-treatments for reactive ion etching of Al-Si-Cu alloys'

## Description

In the manufacture of integrated circuits, electrically conductive features are formed on semiconductor substrates by depositing a layer comprising a metal on the substrate, forming a resist composed of polymer or oxide on the layer, and etching the exposed portions of the layer. Especially when halogen-containing etchants, (e.g., Cl₂, BCl₃, CCl₄, SiCl₄, CF₄, NF₃, SF₆ and mixtures thereof, as described for example in Silicon Processing for the VLSI Era, Vol. 1, Chapter 16, by Wolf and Tauber, Lattice Press, 1986, the disclosure of which is incorporated herein by reference) are used to etch the substrate, e.g., in reactive ion etching, the etched substrate is contaminated by etchant residues and byproducts. These contaminants, particularly in conjunction with ambient moisture, can corrode the conductive features, especially when the features are composed of alloys which can galvanic couple, such as Al-Cu or Ti-W. The contaminant byproducts are, for example, produced by reaction between residual halogen from the etchant, metal in the conductive features and/or polymeric resist material. They may be in the form of sidewall deposits formed by condensation of reaction byproducts on sides of the conductive features. Also, after etching, remnant resist which is not etched by the etchant gases can remain on the substrate.

It is known to treat the etched substrate to reduce the adverse effects of such contaminants and to remove the remnant resist on the substrate. The substrate treatments can include (i) removing the remnant resist (usually referred to as stripping), (ii) removing or changing the contaminant (usually referred to as passivation, for example, through exposure to a CF₄ plasma), and/or (iii) forming a protective layer over part or all of the conductive feature (usually referred to as inhibition, for example through exposure to a CHF₃ plasma).

For example, US-A-5 174 856 discloses a process for removal of photoresist and for inactivation of corrosion-forming materials remaining after metal etch process. The process includes a first stripping step using a plasma of either O₂ gas or a combination of O₂ gas and N₂ and/or a fluorocarbon gas, followed by a subsequent plasma step using a combination of O₂ and NH₃. In another example, EP-A-0 416 774 discloses a post-etch treatment for samples of aluminum-containing wiring films which involves treating the sample with (i) a plasma of a gas having an oxygen component to remove the resist on the wiring material by reacting with oxygen, and (ii) a subsequent treatment in a plasma gas having a hydrogen component causing reaction of the hydrogen with the halogen component (Cl, Br, etc.) adhered to the wiring material to form HCl or HBr.

However, known stripping, passivation and inhibition treatments require excessively long treatment times and/or require the use of materials or equipment which are expensive, difficult or dangerous to use.

Also, known passivation and stripping methods can become ineffective and allow corrosion of the substrate too quickly, e g., in 1 to 5 hours. It is generally important to prevent corrosion of the etched features on the substrate for at least until the next step in the processing of the substrate (typically a stripping treatment which removes the resist and/or at least some of the contaminants). If the treatment which prevents corrosion is effective for only a short time, this places serious constraints on the timing of the production process and can result in the loss of an entire batch of wafers if there is an unexpected delay in production caused for example by an equipment failure.

We have discovered, in accordance with the invention, a multicycle passivation and stripping process, which allows treating an etched substrate to reduce or remove etchant byproducts and remnant resist thereon. In the passivating step, passivating gas is introduced into the chamber **52** and plasma is generated from the passivating gas to passivate the substrate **20.** In the stripping step, stripping gas is introduced into the chamber, and a plasma is generated from the stripping gas to strip the remnant resist on the substrate **20.** The stripping and passivating steps are repeated at least once, in the same order that steps were originally done. In the process, the passivating step can be performed before the stripping step, or vice versa.

The invention is defined by the appended claims.

### DESCRIPTION

The description of the drawings below include a recitation of preferred and exemplary features.
Figure 1a is a schematic view in vertical cross-section of a substrate with etched metal-containing features, showing etchant byproducts, remnant resist, and sidewall deposits thereon;
Figure 1b is a schematic view in vertical cross-section of the substrate of Figure 1a after passivating and stripping showing removal of the etchant byproducts and remnant resist;
Figure 1c is a schematic view in vertical cross-section of the substrate of Figure 1b after removal of the sidewall deposits;
Figure 2 is a schematic view in vertical cross-section of a vacuum chamber suitable for practicing the process of the present invention.

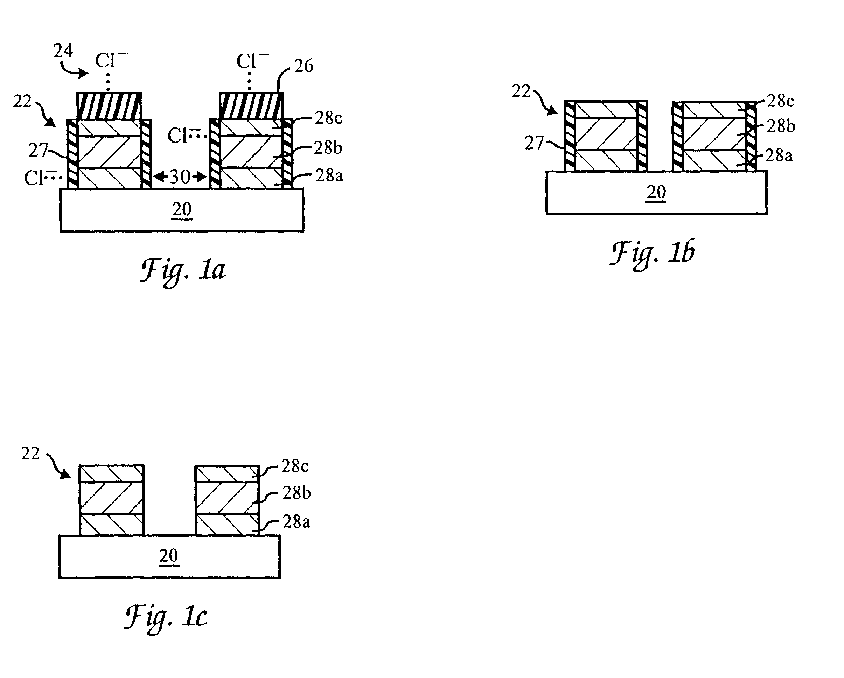

The process of the present invention is performed on an etched substrate **20** typically comprising a semiconducting material, such as silicon or gallium arsenide. The conductive features **22** on the substrate **20** preferably comprise a metal layer, for example, aluminum, an aluminum alloy such as an Al-Cu alloy, copper, and optionally silicon, and may also include a diffusion barrier layer comprising for example Ti, W, a Ti-W alloy, or TiN, and/or an antireflective layer comprising for example Si, TiN, or a Ti-W alloy. The substrate **20** has etched conductive features **22** with (i) etchant byproducts **24,** (ii) remnant resist **26,** and (iii) sidewall deposits **27** on the sidewalls of the features **22,** as schematically shown in Figure 1a. The etchant byproducts **24** on the features **22** typically comprise residual halogen containing radicals and compounds that are formed during etching of the substrate **20.** The remnant resist **26** are those portions of the resist that remain on the substrate after etching. The sidewall deposits **27** on the features **22** typically comprise organic compounds containing (i) carbon and hydrogen, (ii) metal from the metal-containing layers, such as aluminum, and (iii) etchant gas species such as boron and nitrogen.

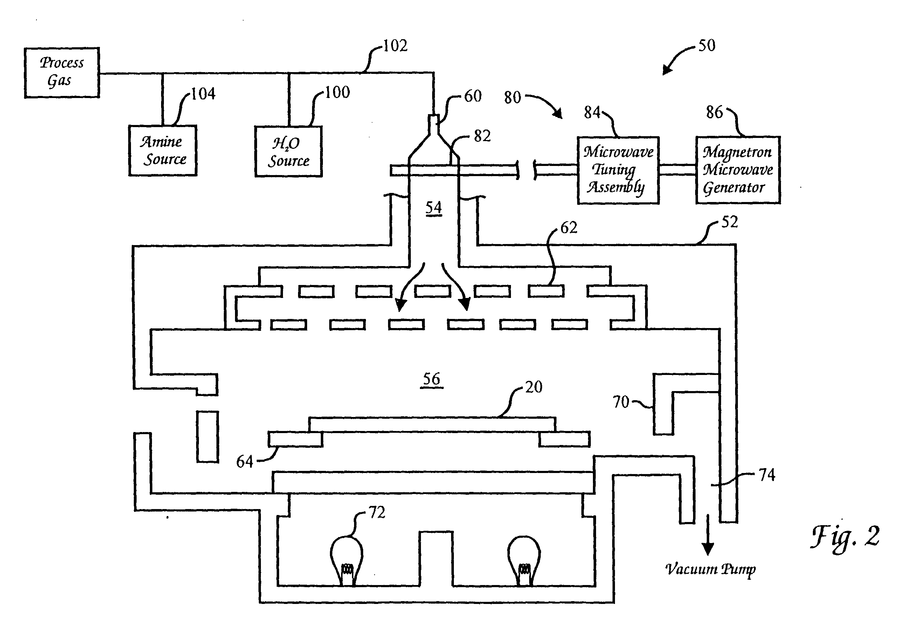

An apparatus **50** suitable for passivating, stripping and inhibiting corrosion of the substrate **20** is schematically shown in Figure 2. The apparatus **50** comprises an etch chamber (not shown) connected by a load-lock transfer area maintained in vacuum (also not shown) to a vacuum chamber **52** having a plasma generation zone **54** and a vacuum zone **56.** Process gases enter the vacuum chamber **52** through a gas inlet **60,** and are uniformly distributed in the vacuum zone **56** by a "showerhead" type diffuser **62**. A substrate support **64** which can comprise a "basket" hoop support (as shown), or a pedestal (not shown), is provided for holding the substrate **20** in the vacuum chamber, and a focus ring **70** maintains the process gas flow around the substrate **20.** A heat source, such as infrared lamps **72,** can be used to heat the substrate **20.** Gaseous byproducts and spent process gas are exhausted from the vacuum chamber **52** through an exhaust **74** via an exhaust system (not shown) capable of maintaining a pressure of at least about 0,133 Pa (1 mTorr) in the vacuum chamber **52.**

A microwave plasma generator assembly **80** connected to the plasma generation zone **54** of the apparatus **50** can be used to generate a plasma from the process gas. A suitable microwave generator assembly **80** is an "ASTEX" Microwave Plasma Generator commercially available from the Applied Science & Technology, Inc., Woburn, Massachusetts. Typically, the microwave generator assembly **80** comprises a microwave applicator **82,** a microwave tuning assembly **84,** and a magnetron microwave generator **86.** Alternative plasma generating sources, such as RF-generated plasmas and inductive coupled plasmas are also effective.

To perform the process of the present invention, an etched substrate **20** is transferred to the vacuum chamber **52** which is maintained at suitable temperature and pressure. A multicycle process comprising either (i) multiple passivating steps, or (ii) multiple passivating and resist stripping steps, is then used to treat the etched substrate to reduce the adverse effect of etchant residues and byproducts on the substrate.

The multicycle process comprises both stripping and passivating steps so that remnant resist and etchant byproducts can be simultaneously removed from the substrate. In the passivating step, passivating gas is introduced into the chamber **52** and plasma is generated from the passivating gas to passivate the substrate **20.** In the stripping step, stripping gas as described below, is introduced into the chamber, and a plasma is generated from the stripping gas to strip the polymeric resist or oxide hard mask on the substrate **20.** The stripping and passivating steps are repeated at least once, in the same order that steps were originally done. In the process, the passivating step can be performed before the stripping step, or vice versa. Typically, a stabilization step is performed between each process step, during which the process conditions for the successive step are stabilized.

Generally, a larger number of cycles provides higher corrosion resistance of the processed substrate **20,** even if the total time duration of the entire process is not increased. However, because a smaller number of cycles provides faster process throughput, particularly when the duration of the stabilization period between each process step is long, the number of cycles is preferably from more than 1 to 10 cycles, and more preferably from 2 to 5 cycles.

Preferably, each passivating step and stripping step of the multicycle process has a duration ranging from about 1 to about 60 seconds, more preferably from 2 to 30 seconds, and most preferably from 2 to 20 seconds. In the multicycle passivating and stripping processes, the passivating step within each cycle has typically the same duration as the stripping step within the same cycle, however, these steps can also have different durations.

Suitable passivating gases for use in the multicycle process include any gas capable of reacting with the etchant byproducts **24** on the substrate **20** to form gaseous byproducts which can be exhausted from the vacuum chamber **52**. For example, when the etchant byproducts **24** comprise chlorine, the passivating gas can comprise a hydrogencontaining gas which reacts with the chlorine to form etchant byproducts such as hydrochloric acid vapor, which is exhausted from the chamber **52.** Suitable passivating gases include water vapor, with optional oxygen and nitrogen.

Alternatively, a passivating gas comprising only water vapor can be used to passivate the etchant byproducts **24.** When the vacuum chamber **52** has a five-liter capacity, the water vapor flow rate is preferably from about 100 to 1000 sccm, and more preferably about 500 sccm. For passivating gas comprising water vapor, optimal corrosion results were achieved using a three-cycle multicycle process comprising passivation and stripping steps having a duration of 20 seconds each. The water vapor is formed in a boiler or bubbler **100** containing water which is connected to the vacuum chamber **52** by the feedline **102.** The boiler or bubbler is maintained at a sufficiently high temperature and at a sufficiently low pressure to vaporize the water. When a boiler is used, the water in the boiler is heated to a temperature close to the boiling point of water. Typically, the pressure in the boiler ranges from about 66,5 hPa - 266 hPa (50 Torr to about 200 Torr), and more typically ranges from 133 hPa - 200 hPa (100 Torr to 150 Torr). When a bubbler is used, an inert carrier gas such as argon or helium can be passed through the bubbler to transport water vapor to the vacuum chamber **52.**

Preferred gases which can be used in the multicycle processes comprise water vapor, oxygen, and nitrogen. Depending on the ratio by volume of (i) water vapor (V_{H20}) to (ii) oxygen and nitrogen together (V_{O2} + V_{N2}), the process gas can have primarily a passivating function, or primarily a stripping function. When the ratio by volume of V_{H20}:(V_{O2} + V_{N2}) is from about 1:2 to about 2:1, preferably 0.8:1 to 1:0.8, and especially about 1:1, the process gas functions primarily as a passivating gas; and a separate resist stripping step is used to remove the resist on the substrate. When the ratio by volume of V_{H20}:(V_{O2} + V_{N2}) is from about 1:4 to about 1:40, preferably 1:6 to 1:20, and especially about 1:10, the process gas functions primarily as a stripping gases and a separate passivation step can be used to passivate the substrate. To serve primarily as a stripping gas, the water vapor content should be less than about 20% by volume of the combined oxygen and nitrogen gas content to provide adequate stripping rates. It is believed that the water vapor addition results in passivation of some of the etchant byproducts, thus allowing simultaneous stripping and passivating of the substrate. In either process gas mixture, the ratio by volume of oxygen to nitrogen is preferably from about 1:1 to about 50:1, and more preferably from 1:1 to 20:1, and especially about 10:1.

A suitable stripping gas to strip polymeric resist in the multicycle stripping and passivating process comprises (i) oxygen, and (ii) an oxygen activating gas or vapor, such as water vapor, nitrogen gas, or fluorocarbon gas, the fluorocarbon gases including CF₄, C₂F₆, CHF₃, C₃H₂F₆, and C₂H₄F₂ (as for example disclosed in U.S. Patent No. 5,221,424, to Rhoades, and U.S. Patent No. 5,174,856 to Hwang, et al.). For example, a preferred stripping gas comprises oxygen and nitrogen in a volumetric flow ratio of about 6:1 to about 200:1, and more preferably from 10:1 to 12:1, for example, a suitable gas flow rate for a 5-liter vacuum chamber **52** comprises 3000 to 3500 sccm of O₂ and 300 sccm of N₂.

In the multicycle process, the pressure and temperature of the vacuum chamber **52** can be varied between successive passivating or stripping step, or varied between successive cycles, or maintained substantially constant. Preferably, the vacuum chamber **52** is maintained at a pressure ranging from about 1,33 hPa - 133 hPa (1 to about 100 Torr), more preferably from 1,33 hPa - 13,3 hPa (1 to 10 Torr), and most preferably at 2,66 hPa (2 Torr). Optionally, in a second step or cycle the pressure in the chamber **52** is reduced to a second lower pressure of less than about 1,33 hPa (1 Torr,) more typically less than 0,665 hPa (500 mTorr,) and most typically less than about 13,3 hPa (100 mTorr). Typically, the substrate **20** is heated using the lamp heaters **72** to a temperature of from about 150°C to about 400°C, and more preferably from 200°C to 380°C. Preferably, the change in pressure and temperature between successive steps is minimized to increase process throughput efficiency.

A plasma is formed from the stripping or passivating gas using the microwave plasma generator **80** of the apparatus **50.** When the plasma causes the substrate **20** to heat up, the power level of the microwave generator **80** is regulated so that the temperature of the substrate remains substantially constant. Typically, the power output of the microwave generator **80** ranges from 500 to 2500 Watts, and more preferably from 800 to 1500 Watts.

The multicycle passivating and stripping processes have demonstrated faster throughput, and superior corrosion resistance than prior art processes. It is believed the stripping steps remove portions of the remnant resist **26** and sidewall deposits **27** thereby making the remnant resist **26** and the sidewall deposits **27** thinner and more porous, and enhancing both diffusion of passivating species into the remnant resist **26,** and diffusion of reaction products out of the resist **26.** The multicycle process provides a substrate that is resistant to corrosion by ambient moisture for at least 24 hours, and more typically at least 48 hours, after passivation of the substrate. This is a substantial improvement over prior art processes, which typically provide corrosion resistance for only about 1 to 2 hours. The improved corrosion resistance allows more efficient processing schedules and reduces manufacturing losses.

### EXAMPLES

The following examples illustrate the process of the present invention. All the examples were performed in an "AMAT PRECISION 5000 METAL ETCHER" system, commercially available from Applied Materials, Santa Clara, California. The "PRECISION 5000" apparatus had an etching chamber (not shown) connected to the passivating and stripping chamber (as shown), so that the substrate can be transferred from the etching chamber to the passivating and stripping chamber without exposure to the atmosphere. The etch chamber of the apparatus (not shown) also comprised an inductive coil encircling the chamber for optionally generating a magnetic field to enhance the intensity of the plasma in the chamber. The experiments were performed on silicon wafers having a diameter of about 200 mm (8 inches) and a thickness of 0.73 mm.

After passivating and stripping, the corrosion resistance of the substrates was tested by exposing the processed substrates to atmosphere or exposing the substrate to elevated moisture levels ranging up to about 40% relative humidity for set intervals of time, and thereafter examining the substrates in a microscope under dark field conditions, or in a scanning electron microscope. Corrosion of the substrate was visible as specks of scattered light caused by the corroded hydroscopic species formed on the metal features. The corrosion was measured either directly after the passivating and stripping steps, at intervals of 2 hours to 7 days; or alternatively, after a wet etching step was performed and at intervals of 1, 2, and 3 weeks.

### Examples 1-11

In these examples, either single or multicycle passivating and strip processes were performed on substrates having features comprising (i) TiW barrier layer; (ii) an aluminum-silicon-copper conductive metal layer approximately 550 nm thick, the aluminum alloy containing 1.5% silicon and 0.5% copper; and (iii) an antireflective layer of titanium. The substrates previously were etched in an reactive ion etching process using a BCl₃, Cl₂, and N₂ gas mixture.

The single cycle processes are mentioned for comparative purpose only; they do not form part of the present invention:

The process conditions and the results of the corrosion tests for Examples 1-11 are described in Table I. The passivating step was effected using water vapor flowed at a volumetric flow rate of 500 sccm. The stripping step was performed using a stripping gas comprised of oxygen, nitrogen, and optionally water vapor in the described flow rates. In all the processes, the vacuum chamber was maintained at a pressure of 266 Pa (2 Torr.) Generally, the multicycle passivating and stripping processes provided superior corrosion results compared to the single cycle processes.

The multicycle passivating and stripping process used for Example 7 provided the best corrosion resistance. In this process, each passivating and stripping step was 20 seconds in duration, and the passivating and stripping steps were repeated three times. Corrosion resistance of greater than 72 to 96 hours was obtained.

Comparison of Examples 6 and 7 suggests that for the same total multicycle process time, an increased number of cycles provide better corrosion resistance.

In comparing Examples 7 and 9, it is observed that a final stripping step substantially increases the corrosion resistance of the substrate. In Example 9, where the final stripping step was not performed, a corrosion resistance of 3 to 7 hours was observed; whereas in Example 7, a corrosion resistance exceeding 72 hours was observed. It is believed that a final stripping step increases corrosion resistance because the oxygen in the stripping gas oxidizes the aluminum in the features, forming a thin protective layer of aluminum oxide on the metal features.

Example 11 demonstrates that the fastest total processing time can be achieved by increasing the number passivating and strip cycles.

**TABLE I**

| | H₂O Passivating Step | | | Stripping Step¹ | | | Cycles | Total Time | Hours of Corrosion Resistance |
|---|---|---|---|---|---|---|---|---|---|
| Example | RF Power (Watts) | Temp (°C) | Duration (Sec) | Gas Composition (sccm) | Temp (°) | Duration (Sec) | (No) | (Sec) | (Hours) |
| 1 | None | None | None | O₂:3000 N₂:200 H₂O:300 | 300 | 40 | 1 | 40 | ≤2 |
| 2 | 800 | 250 | 40 | None | None | None | 1 | 40 | ≤2 |
| 3 | 800 | 250 | 90 | None | None | None | 1 | 90 | ≥2 ≤24 |
| 4 | 800 | 250 | 80 | O₂:3000 N₂:200 | 250 | 60 | 1 | 120 | ≤2 |
| 5 | 1400 | 250 | 150 | None | None | None | 1 | 150 | ≤2 |
| 6 | 1400 | 220 | 30 | O₂:3000 N₂:200 | 250 | 30 | 2 | 120 | ≤7 |
| 7 | 1400 | 200 | 20 | O₂:3000 N₂:200 H₂O:300 | 220 | 20 | 3 | 120 | ≥72 to 96² |
| 8 | 1400 | 200 | 10 | O₂:3000 N₂:200 H₂O:300 | 220 | 10 | 3 | 60 | ≤2 |
| 9 | 1400 | 200 | 20 | O₂:3000 N₂:200 H₂O:300 | 220 | 20 | 3/2³ | 100 | ≥ 3 ≤7 |
| 10 | 1400 | 200 | 20/10 | O₂:3000 N₂:200 H₂O:300 | 220 | 20/10 | 2 | 80 | ≥3 ≤24 |
| 11 | 1400 | 220 | 10 | O₂:3000 N₂:200 H₂O:300 | 220 | 10 | 5 | 100 | ≥72 |

| | | | | | | | | | |
|---|---|---|---|---|---|---|---|---|---|
| (1) For all stripping steps, the RF power applied to the microwave generator was maintained at 1400 Watts. | | | | | | | | | |
| (2) Repeatability was demonstrated for this example. | | | | | | | | | |
| (3) Three passivating cycles + two stripping cycles. | | | | | | | | | |

## Claims

1. A process for passivating halogen-containing contaminants of etchant byproducts [5,15; 2,3] on a substrate by removing [3,3] or changing the halogen-containing contaminants and stripping by removing the remnant resist [2,3], the process comprising the steps of:
(a) placing the substrate into a vacuum chamber;
(b) passivating the etchant by products by removing or changing the halogen-containing contaminants the etchant residue, by introducing into the vacuum chamber a plasma of gas comprising a water vapor wherein said passivating step has a duration of 10 to 30 s [6,13] and is performed at a temperature of 200°C to 250°C;
(c) before or after step (b), stripping resist from the substrate by introducing a stripping gas into the vacuum chamber and forming a plasma from the stripping gas, wherein said stripping gas comprises oxygen and nitrogen and wherein said stripping process is performed at a temperature of 200 to 250°C [9,1];
(d) repeating steps (b) and (c) at least once [6, 10] in the same order that steps (b) and (c) were done, wherein the total time for the multicycle passivating and stripping steps is at least 100 s [Example 11; 14,4];
(e) removing the substrate from the chamber.

2. A process according to claim 1 **characterized in that** the same composition of passivating gas is used in each successive repetition of step (b).

3. A process according to claim 1 **characterized in that** the stripping gas comprises oxygen and nitrogen with the volumetric ratio of (i) oxygen and (ii) nitrogen being 30:2.

4. A process according to claim 3 **characterized in that** the stripping gas comprises water vapor, oxygen and nitrogen, the volumetric ratio of (i) water vapor to (ii) oxygen being 1:10.

5. A process according to claim 1 **characterized in that** during the passivating step, a pressure from 0.1333 hPa to 133.3 hPa.

## Patentansprüche

1. Verfahren zum Passivieren von Halogen enthaltenden Verunreinigungen von Ätzmittelnebenprodukten [5,15; 2,3] auf einem Substrat durch Entfernen [3,3] oder Verändern der Halogen enthaltenden Verunreinigungen und Ablösen durch Entfernen des restlichen Resists [2,3], wobei das Verfahren die Schritte umfasst:
(a) Legen des Substrats in eine Vakuumkammer;
(b) Passivieren der Ätzmittelnebenprodukte durch Entfernen oder Verändern der Halogen enthaltenden Verunreinigungen des Ätzmittelrests durch Einleiten eines Plasmas aus Gas mit einem Wasserdampf in die Vakuumkammer, wobei der Passivierungsschritt eine Dauer von 10 bis 30 s [6,13] aufweist und bei einer Temperatur von 200°C bis 250°C durchgeführt wird;
(c) vor oder nach Schritt (b) Ablösen von Resist vom Substrat durch Einleiten eines Ablösegases in die Vakuumkammer und Erzeugen eines Plasmas aus dem Ablösegas, wobei das Ablösegas Sauerstoff und Stickstoff umfasst und wobei der Ablöseprozess bei einer Temperatur von 200 bis 250°C durchgeführt wird [9,1];
(d) mindestens einmal Wiederholen der Schritte (b) und (c) [6,10] in derselben Reihenfolge wie die Schritte (b) und (c) durchgeführt wurden, wobei die Gesamtzeit für die Passivierungs- und Ablöseschritte mit mehreren Zyklen mindestens 100 s beträgt [Beispiel 11; 14,4];
(e) Entnehmen des Substrats aus der Kammer.

2. Verfahren nach Anspruch 1, **dadurch gekennzeichnet, dass** dieselbe Zusammensetzung des Passivierungsgases bei jeder fortlaufenden Wiederholung von Schritt (b) verwendet wird.

3. Verfahren nach Anspruch 1, **dadurch gekennzeichnet, dass** das Ablösegas Sauerstoff und Stickstoff umfasst, wobei das Volumenverhältnis von (i) Sauerstoff und (ii) Stickstoff 30:2 beträgt.

4. Verfahren nach Anspruch 3, **dadurch gekennzeichnet, dass** das Ablösegas Wasserdampf, Sauerstoff und Stickstoff umfasst, wobei das Volumenverhältnis von (i) Wasserdampf zu (ii) Sauerstoff 1:10 beträgt.

5. Verfahren nach Anspruch 1, **dadurch gekennzeichnet, dass** während des Passivierungsschritts ein Druck von 0,1333 hPa bis 133,3 hPa herrscht.

## Revendications

1. Procédé de passivation de contaminants contenant un halogène de sous-produits d'agent de gravure [5,15 ; 2,3] sur un substrat en éliminant [3,3] ou en changeant les contaminants contenant un halogène et de décapage en éliminant le résist restant [2,3], le procédé comprenant les étapes consistant à
(a) placer le substrat dans une chambre à vide,
(b) passiver les sous-produits d'agent de gravure en éliminant ou en changeant les contaminants contenant un halogène du résidu d'agent de gravure, en introduisant dans la chambre à vide un plasma de gaz comprenant une vapeur d'eau, dans lequel ladite étape de passivation présente une durée de 10 à 30 s [6, 13] et est exécutée à une température de 200 °C à 250 °C,
(c) avant ou après l'étape (b), décaper le résist du substrat en introduisant un gaz de décapage dans la chambre à vide et en formant un plasma à partir du gaz de décapage, dans lequel ledit gaz de décapage comprend de l'oxygène et de l'azote et dans lequel ledit procédé de décapage est exécuté à une température de 200 à 250 °C [9, 1],
(d) répéter les étapes (b) et (c) au moins une fois
[6, 10] dans le même ordre suivant lequel les étapes (b) et (c) ont été exécutées, le temps total pour les étapes de passivation et de décapage à plusieurs cycles étant d'au moins 100 s [exemple 11 ; 14, 4],
(e) enlever le substrat de la chambre.

2. Procédé selon la revendication 1, **caractérisé en ce que** la même composition de gaz de passivation est utilisée dans chaque répétition successive de l'étape (b).

3. Procédé selon la revendication 1, **caractérisé en ce que** le gaz de décapage comprend de l'oxygène et de l'azote, le rapport volumétrique de (i) l'oxygène et (ii) l'azote étant de 30:2.

4. Procédé selon la revendication 3, **caractérisé en ce que** le gaz de décapage comprend de la vapeur d'eau, de l'oxygène et de l'azote, le rapport volumétrique de (i) de la vapeur d'eau sur (ii) l'oxygène étant de 1:10.

5. Procédé selon la revendication 1, **caractérisé en ce que** durant l'étape de passivation, une pression de 0,1333 hPa à 133,3 hPa est appliquée.
